(19) Europäisches Patentamt

European Patent Office

Office européen des brevets

(11) **EP 0 602 435 B1**

(12) **EUROPÄISCHE PATENTSCHRIFT**

(45) Veröffentlichungstag und Bekanntmachung des Hinweises auf die Patenterteilung:
**30.09.1998 Patentblatt 1998/40**

(51) Int Cl.⁶: **H03D 3/00**

(21) Anmeldenummer: **93119146.4**

(22) Anmeldetag: **27.11.1993**

(54) **Verfahren zur Demodulation von frequenzmodulierten Signalen**

Demodulation method for frequency-modulated signals

Méthode de démodulation pour des signaux modulés en fréquence

(84) Benannte Vertragsstaaten:
**AT CH ES GB IT LI**

(30) Priorität: **12.12.1992 DE 4241965**

(43) Veröffentlichungstag der Anmeldung:
**22.06.1994 Patentblatt 1994/25**

(73) Patentinhaber: **ROBERT BOSCH GMBH**
**70442 Stuttgart (DE)**

(72) Erfinder: **Göckler, Heinz, Dr.-Ing.**
**D-71522 Backnang (DE)**

(56) Entgegenhaltungen:
**EP-A- 0 184 018**     **DE-C- 3 716 018**
**DE-C- 3 836 081**     **US-A- 4 468 794**
**US-A- 5 057 786**

**Beschreibung**

Die Erfindung betrifft ein Verfahren zur Demodulation von frequenzmodulierten Signalen gemäß Oberbegriff des Anspruches 1. Solche digitale Verfahren zur Demodulation von kontinuierlich modulierten FM-Signalen, also nicht FSK, welche zum eigentlichen Demodulationsprozeß komplexwertige Signale benötigen und verarbeiten, sind bekannt, beispielsweise durch den Aufsatz "Equalization Problems in a digital FM Receiver" von Kammeyer in Signal Processing 9 (1985) Seiten 263-276, wobei es sich um einen sogenannten Verzögerungsdemodulator handelt.

Aus der DE 38 36 081 C1 ist eine Filterbank zum Frequenzmultiplexen bzw. Frequenzdemultiplexen von Kanalsignalen bekannt, deren Ziel eine Vereinheitlichung der Gesamtanordnung der Filterbank durch Verminderung der Vielzahl unterschiedlicher Filter bzw. unterschiedlicher Filterkoeffizienten ist. Die Filterbank besteht aus einer Anzahl L von Transversalfiltern mit komplexwertigen Koeffizienten für reellwertige Eingangssignale und mit komplexwertigen Ausgangssignalen. Die Abtastrate am Ausgang ist gegenüber dem Eingang um den Faktor M reduziert oder erhöht, wobei die L Filter durch eine Kaskadierung von mehreren Filtern realisiert sind und in jeder Kaskadenstufe die Abtastrate um einen Faktor $M_q$ reduziert bzw. erhöht ist. Jeweils in den einzelnen Filterkaskaden vor der gleichen Kaskadenstufe ist ein komplexer Multiplizierer eingefügt, der das komplexwertige Ausgangssignal des Filters der vorhergehenden Kaskadenstufe mit der komplexen Folge einer komplexen Trägerschwingung multipliziert.

Aus der DE 37 16 018 C1 ist eine Filterbank ebenfalls zum Frequenzmultiplexen bzw. -demultiplexen von einer Anzahl L von Kanalsignalen bekannt. Sie besteht aus L Transversalfiltern mit komplexwertigen Koeffizienten für reellwertige Eingangssignale und mit komplexwertigen Ausgangssignalen; die Abtastrate am Ausgang ist gegenüber dem Eingang um den Faktor M reduziert oder erhöht. Mindestens eines der L Filter ist durch eine Kaskadierung von mindestens zwei Filtern mit jeweils komplexwertigen Koeffizienten realisiert, wobei bei jedem dieser Filter die Abtastrate um den Faktor $M_q > 1$ reduziert bzw. erhöht ist, wobei die Summe aller $M_q = M$ ist. Die Eingangsfilter der Kaskade nehmen jeweils ein reellwertiges Eingangssignal auf und geben ein komplexes Ausgangssignal ab, während die anderen Filter der Kaskade jeweils ein komplexwertiges Eingangssignal aufnehmen und ein komplexwertiges Ausgangssignal abgeben.

In der US-Patentschrift 5 058 786 ist ein Quadraturamplitudendemodulator beschrieben, der eingangsseitig zwei Bandpaßfilter enthält. Eines der Bandfilter liefert am Ausgang ein Signal, das in Phase mit der eingangsseitigen Trägerwelle ist, während das andere Bandpaßfilter eine Quadraturkomponente liefert. Den Bandpaßfiltern ist eine Einrichtung zur Vektormultiplikation der Ausgangssignale der Bandpaßfilter jeweils mit Referenzträgerwellen nachgeschaltet, die zu einander in Quadratur stehen.

In der US-Patentschrift 4 468 794 ist ein in Digitaltechnik aufgebauter, kohärenter Detektor zur Abtastung eines bandbegrenzen Zwischenfrequenzsignals beschrieben, der dazu dient, seine Inphase- und Quadraturkoeffizienten zu liefern, ohne Quadraturkanäle zu benutzen.

Aus der Dissertation "Die Demodulation frequenzumgetasteter Signale mit Bandbreiten in der Größenordnung der Mittenfrequenz" von Ruopp, Universität Stuttgart 1975 ist die Blockstruktur eines mit Differentiation arbeitenden Demodulationsverfahren bekannt geworden.

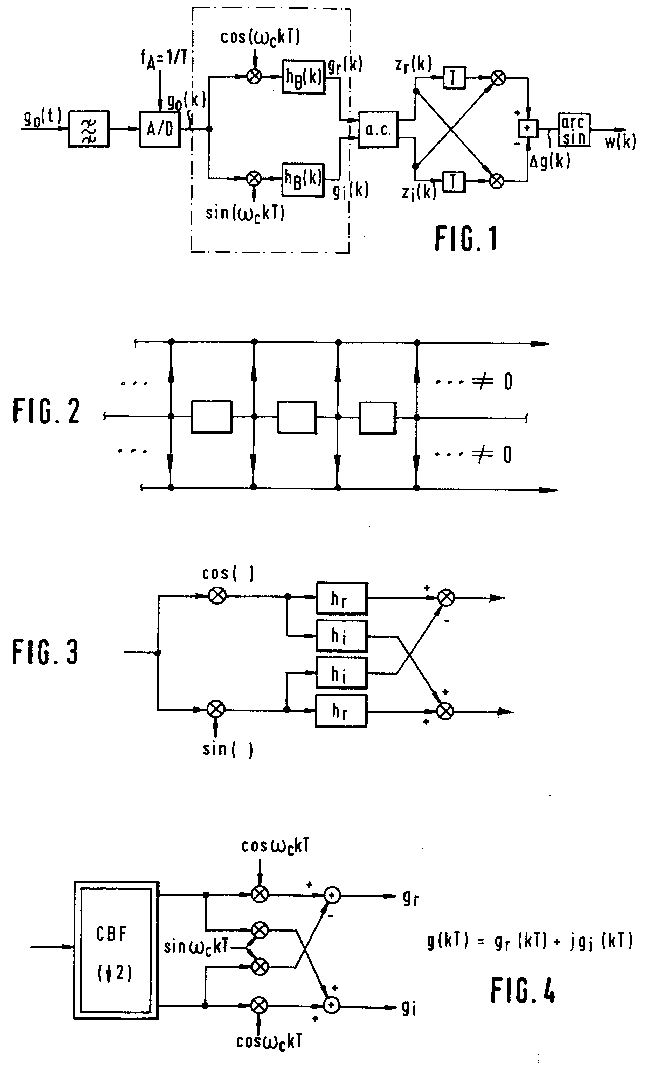

Bei all diesen Verfahren ist es erforderlich, aus den urprünglich reellwertigen FM-Eingangssignal $g_o$ (t) komplexwertige Signale abzuleiten in Form einer Normal- und einer Quadraturkomponente (Real- und Imaginärteil). Diese Komponenten werden erzeugt, indem das abgetastete Eingangssignal mit zwei zueinander orthogonalen Trägersignalen multipliziert wird (Mischer) und anschließend mittels zweier nachgeschalteter identischer Tiefpässe zur Unterdrückung unerwünschter Mischprodukte gefiltert werden. Diese dazu notwendige Schaltungsanordnung ist in Figur 1 strichliert umrandet.

Wenn die Filterkombination $h_B$ zusätzlich die Aufgabe übernehmen soll, den bezüglich der Mittenfrequenz unsymmetrischen Frequenzgang des analogen Vorfilters zu entzerren, dann enthält der gestrichelte Block der Figur 1 vier Teilfilter, wie in Figur 3 gezeigt wird.

Der vorliegenden Erfindung lag die Aufgabe zugrunde, ein Verfahren der eingangs genannten Art anzugeben, welches in der Lage ist, Demodulationssignale gleicher oder sogar höherer Qualität zu erzeugen unter Verminderung des Aufwandes.

Diese Aufgabe wurde gelöst mit den Mitteln des Anspruches 1. Vorteilhafte Ausgestaltungen ergeben sich durch die Unteransprüche.

Das erfindungsgemäße Demodulationsverfahren erfordert wesentlich weniger Schaltungsaufwand und liefert qualitativ mindestens gleichwertige Demodulationsprodukte. Das Verfahren ist auch dann anwendbar, wenn beliebige Frequenzverschiebung gewünscht wird.

Es folgt nun die Beschreibung anhand der Figuren.

Die Figur 1 zeigt das grundlegende Blockdiagramm für einen digitalen FM-Demodulator nach Kammeyer.

Die Figur 3 zeigt die Anordnung aus vier Teilfiltern, wenn die Filterkombination $h_B$ in dem strichlierten Block der Figur 1 zusätzlich die Aufgabe der Entzerrung übernimmt.

Die Figur 4 schließlich zeigt eine Anordnung, die nach dem erfindungsgemäßen Verfahren arbeitet. In Figur 5 und 6 sind Strukturen für ein Prototypfilter zur Erzeugung eines komplexwertigen Ausgangssignals aus einem reellwertigen Eingangssignal dargestellt.

Im Blockschaltbild gemäß Figur 1 werden die einzelnen Verarbeitungsschritte des eingangsseitigen Empfangssignals gezeigt:

Das durch den Zwischenfrequenzmischer in eine Zwischenfrequenzlage auf die Mittenfrequenz $f_o$ heruntergemischte Empfangssignal $g_0$ (t) wird über ein analoges Vorfilter auf einen Analog/Digitalumsetzer geleitet, abgetastet und anschließend mittels zweier orthogonalen Trägersignale der Frequenz $f_c$ in ein komplexwertiges Signal gewandelt, welches über die Tiefpaßfilterfunktion $h_B$ in beiden Zweigen von störenden Mischprodukten befreit wird. Daran anschließend erfolgt eine Amplitudenregelung, womit eine Entzerrung der Amplitude vorgenommen wird, welche auf der Übertragungsstrecke linearen Verzerrungen ausgesetzt war. Nach der Amplitudenregelung folgt der eigentliche Demodulator, hier ein Verzögerungsdemodulator welcher mittels einer komplexen Multiplikation der folgenden Form

$$\Delta \, g(k) = Im \, \{\underline{z}(k) \cdot \underline{z}^{*}(k\text{-}1)\}$$

nach Amplitudenregelung a.c. oder

$$\Delta g(k) = Im \, \{\underline{g}(k) \cdot \underline{g}^{*}(k\text{-}1)\} = sin \, [ \, w \, (k)]$$

$$= sin \, [ \, \varphi \, (k)\text{-} \, \varphi(k\text{-}1)]$$

das gewünschte Phaseninkrement erzeugt, woraus dann mittels einer anschließenden Arcussinuskonversion das demodulierte Signal w (k) gewonnen wird: $w \, (k) = \omega_o \cdot T \, [1{+}\alpha \cdot v(k)]$.

In Figur 3 sind die vier Teilfilter zweimal $h_r$ und zweimal·hi erkennbar, welche außer der Filterung $h_B$ nach Figur 1 auch noch die Aufgabe der Entzerrung übernehmen, die aufgrund von Bandbegrenzungen bzw. möglicher Verzerrungen des analogen Vorfilters der Übertragungsstrecke notwendig sein kann.

Die Figur 4 zeigt die erfindungsgemäße Aufbereitung des reellen Eingangssignals in ein komplexwertiges Signal, das anschließend entweder über eine nachfolgende Amplitudenregelung oder direkt einem FM-Verzögerungsdemodulator gemäß Figur 1 zugeführt wird. Das Eingangsfilter für das reelle Eingangssignal weist komplexwertige Koeffizienten auf und arbeitet mit oder ohne Dezimation. Für den Fall, daß das Filter keine Entzerrungsfunktion zu erfüllen hat und die Filtermittenfrequenz $f_o$ exakt bei einem Viertel der Abtastrate liegt, sind nur reelle und imaginäre Koeffizienten vorhanden, sie sind abgeleitet von Filtern mit reellen Koeffizienten z. B. gemäß

$$\underline{h} \, (k) = h(k) \cdot e^{jk\pi/2}$$

$$= \{h(0), \, jh(1), \, \text{-}h(2), \, \text{-}jh(3),...\}.$$

Der Aufwand für dieses komplexe Bandfilter CBF ist der gleiche wie für ein einzelnes Filter $h_B$ gemäß Figur 1. Bei dem erfindungsgemäßen Verfahren kommen allerdings zwei weitere Mischer hinzu, die aber einen wesentlich geringeren Aufwand ausmachen.

Soll das Filter zusätzlich eine Entzerrerfunktion aufweisen, so ist die gleiche Blockstruktur nach Figur 4 verwendbar, wobei allerdings alle Koeffizienten komplex sind (Figur 2). Der Aufwand ist demnoch jeweils halb so groß wie in Figur 3; d. h. man kommt mit einem Paar $h_r$, $h_i$ aus.

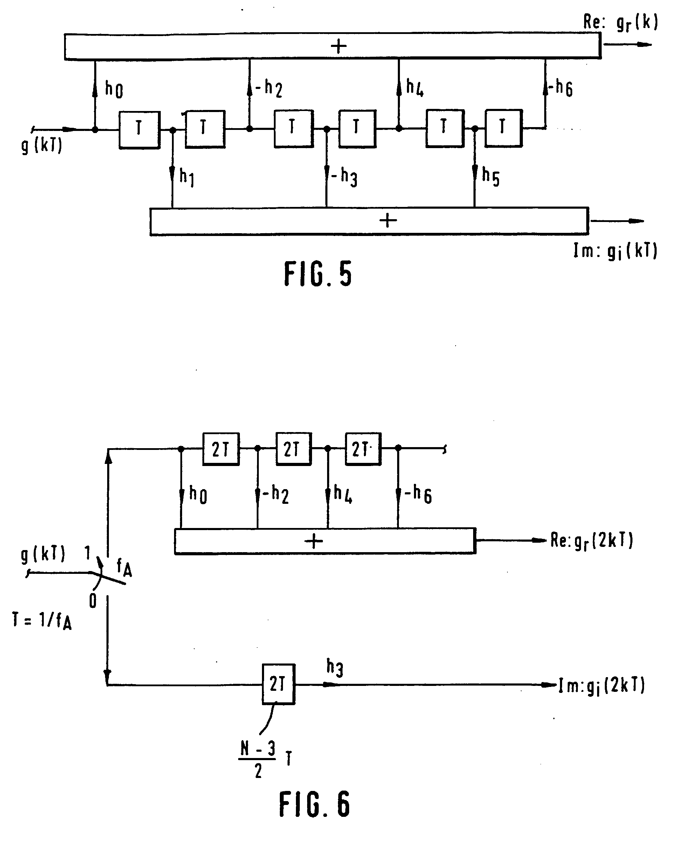

Die Figur 5 zeigt eine Struktur für ein Prototypfilter ohne Dezimation für den Fall, daß die Mittenfrequenz $f_o$ identisch ist mit einem Viertel der Abtastrate. Es handelt sich hier um ein Filter des Grades N = 7. Aufgrund der hier angenommenen Koeffizientensymmetrie $h_o = h_6$, $h_2 = h_4$ und $h_1 = h_5$ läßt sich die Struktur noch weiter vereinfachen.

In Figur 6 ist ein komplexes Halbbandfilter mit Abtastratenhalbierung dargestellt.

Figur 2 zeigt eine Filterstruktur für den allgemeinsten Fall, nämlich mit Entzerrungsfunktion, unabhängig davon, ob die Mittenfrequenz $f_o$ gleich oder ungleich dem Viertel der Abtastrate ist.

**Patentansprüche**

1. Verfahren zur Demodulation von frequenzmodulierten Signalen der Form $g_o(t) = a(t) \cdot cosinus \, [\varphi(t)]$ mit der Augenblickskreisfrequenz

$$\omega(t) = d\,\varphi(t)/dt = \omega_o\,[1 + \alpha \cdot v(t)],$$

wobei das Empfangssignal $g_0(t)$ mit der Abtastfrequenz $f_A = 1/T$ abgetastet wird zu

$$g_o(k) = a(k) \cdot \cos[\varphi(kT)]$$

$$= a(k) \cdot \cos[\omega_o\,kT + \psi(k)],$$

mit

$$\Psi(k) \;=\; \triangle\,\Omega \cdot\cdot T\;\sum_{-\infty}^{k}\;v(k),$$

wobei durch die Abtastung das übertragene Nutzsignal $v(t)$ in die Form $v(k)$ übergeht, mit der Schrittzahl k, mit der Schritt-Taktlänge T, dem Kreisfrequenzhub $\Delta\Omega = \alpha\omega_o$, der Bezugs-Kreisfrequenz $\omega_o$ und mit der durch lineare Verzerrungen der Übertragungsstrecke in zeitlicher Abhängigkeit t schwankenden Amplitude $a(t)$ bzw. $a(k)$, wobei das abgetastete Signal $g_o(k)$ mittels komplexer TrägerMultiplikation mit $e^{j\omega_c kT}$ nach einer neuen Mittenfrequenz $\Delta f = \Delta\omega/2\pi \approx 0$ frequenzverschoben wird und wobei anschließend mittels komplexer Weiterverarbeitung z. B. mittels komplexer Multiplikation

$$\Delta g(k) = \mathrm{Im}\,\{\underline{g}(k)\cdot\underline{g}^*(k\text{-}1)\}$$

bzw.

$$\Delta g(k) = \mathrm{Im}\,\{\underline{z}(k) \cdot \underline{z}^*(k\text{-}1)\}$$

$$\Delta g(k) = \sin[w(k)]$$

$$= \sin[\varphi(k) - \varphi(k\text{-}1)]$$

mit anschließender Arcus-Sinus-Konversion
das gewünschte Phaseninkrement $w(k) = \omega_o \cdot T\,[\Delta\omega/\omega_o + \alpha\cdot v\,(k)]$
und damit das zu übertragende Signal $v(k)$ gewonnen wird, wobei das abgetastete Empfangssignal $g_o(kT)$ vor der komplexen Trägermultiplikation einer Filterung mit einem Bandfilter unterzogen wird, dadurch gekennzeichnet, daß dieses Filter komplexwertige Koeffizienten $\underline{h}(k)$ aufweist, daß die Filter-Mittenfrequenz exakt bei $f_o = f_A/4$ liegt und daß das Filter ein nichtrekursives Halbbandfilter ist mit komplexen Koeffizienten zum Verarbeiten eines reellwertigen Eingangssignals $s(kT)$ unter Halbierung der Abtastfrequenz $f_A = 1/T$ und zum Umwandeln dieses reellwertigen Eingangssignals $s(kT)$ in ein komplexwertiges Ausgangssignal $\underline{s}\,(2kT)$, wobei seine komplexen Koeffizienten $\underline{h}(1)$ mit $1 = -(N\text{-}1)/2$ bis $(N\text{-}1)/2$ und der ungeraden Filterlänge N abwechselnd rein reelle und rein imaginäre Werte aufweisen, wobei die Impulsantwort eines Halb-Band-Filters $h(l)$ mit ausschließlich reellen Werten und den Eigenschaften
$h(l) = h(\text{-}1)$ für alle
$|l| \le (N\text{-}1)/2$ und $h(l) = 0$ für $1 = \pm 2,\ \pm 4,\ldots$ auf den komplexen Träger einer Frequenz von $\pm\,1/4$ der Eingangs-Abtastfrequenz $f_A = 1/T$ moduliert wird zu

$$\underline{h}(l) = h(l)\cdot e^{\,j(\pm 2\pi\cdot f_A/(4\,f_A)+\varphi_o)}$$

$$= j^{\,\pm 1}\cdot e^{\,j\varphi_o} \cdot h(l)$$

und wobei die Nullphase $\varphi_o$ dieses komplexen Trägers ganze Vielfache m von $\pi/2$ beträgt ($\varphi_0 = \pm\,m\cdot\pi/2$ mit m =

0,1,2,3,...).

**2.** Verfahren nach Anspruch 1, dadurch gekennzeichnet, daß das Bandfilter komplexwertige Koeffizienten $\underline{h}(k)$ aufweist, daß die Filter-Mittenfrequenz exakt bei $f_0 = f_A/4$ liegt und daß durch dieses Filter zusätzlich entzerrt wird.

**3.** Verfahren nach Anspruch 2, dadurch gekennzeichnet, daß das reelle Eingangssignal $s(kT)$ unter Beibehaltung der Abtastfrequenz $f_A = 1/T$ und mittels Faltung mit der modulierten Impulsantwort $\underline{h}(1)$ in ein komplexes Ausgangssignal

$$\underline{s}(kT) = s_1(kT) * \underline{h}(l)$$

$$= s_1(k) * h_r(l) + j\, s_1(k) * h_i(l)$$

mit k als laufenden Index umgewandelt wird.

**4.** Verfahren nach Anspruch 1, dadurch gekennzeichnet, daß dieses Filter mittels Frequenzverschiebung aus einem Filter mit reellen Koeffizienten $h(k)$ abgeleitet ist.

**5.** Verfahren nach einem der vorhergehenden Ansprüche, dadurch gekennzeichnet, daß das Empfangssignal einer Amplitudenregelung (a.c.) unterzogen wird.

**Claims**

**1.** Method for demodulation of frequency-modulated signals of the form $g_0(t) = a(t) \cdot \text{cosine}\,[\phi(t)]$ with the instantaneous angular frequency

$$\omega(t) = d\,\phi(t)/dt = \omega_0\,[1 + \alpha \cdot v(t)],$$

the received signal $g_0(t)$ being sampled at the sampling frequency $f_A = 1/T$ becomes

$$g_0(k) = a(k) \cdot \cos\,[\phi(kT)]$$

$$= a(k) \cdot \cos\,[\omega_0\,kT + \psi\,(k)],$$

where

$$\psi(k) = \Delta\Omega \cdot T \sum_{-\infty}^{k} v(k)\,,$$

the transmitted wanted signal $v(t)$ changing as a result of the sampling into the form $v(k)$, with step number k, with the step clock interval T, with the change in angular frequency $\Delta\Omega = \alpha\omega_0$, the reference angular frequency $\omega_0$ and with the amplitude $a(t)$ or $a(k)$ which, as a result of linear distortion of the transmission path, fluctuates as a function of the time t, the sampled signal $g_0(k)$ being frequency-shifted by means of complex carrier multiplication by $e^{j\omega_c kT}$ to a new mid-frequency $\Delta f = \Delta\omega/2\pi \approx 0$ and, subsequently, by means of complex further processing, for example by means of complex multiplication

$$\Delta g(k) = \text{Im}\,\{\underline{g}(k) \cdot \underline{g}^*(k-1)\}$$

or

$$\Delta g(k) = \text{Im} \{\underline{z}(k) \cdot \underline{z}^*(k-1)\}$$

$$\Delta g(k) = \sin [\omega(k)]$$

$$= \sin [\phi (k) - \phi(k-1)]$$

with subsequent arc sine conversion

the desired phase increment $w(k) = \omega_0 \cdot T [\Delta\omega/\omega_0+\alpha\cdot v (k)]$ being obtained, and thus the signal $v(k)$ to be transmitted, the sampled received signal $g_0(kT)$ being subjected before the complex carrier multiplication to filtering with a bandpass filter, characterized in that this filter has complex coefficients $\underline{h}(k)$, in that the filter mid-frequency is exactly at $f_0=f_A/4$, and in that the filter is a non-recursive half-band filter with complex coefficients for processing a real input signal $s(kT)$ with the sampling frequency $fA = 1/T$ being halved and for conversion of this real input signal $s(kT)$ to a complex output signal $\underline{s}(2kT)$ wherein the complex coefficients $\underline{h}(l)$ of the latter, where $l = -(N-1)/2$ to $(N-1)/2$, and the odd-numbered filter length N alternately have purely real and purely imaginary values, wherein the impulse response of a half-band filter $h(l)$ is modulated with exclusively real values and the characteristics $h(l) = h(-1)$ for all values of $|l| \leq (N-1)/2$ and $h(l) = 0$ for $1 = \pm2, \pm4,...$ onto the complex carrier at a frequency of $\pm 1/4$ of the input sampling frequency $f_A = 1/T$ to give

$$\underline{h}(l) = h(l) \cdot e^{j}(\pm2\pi f_A/(4 f_A)+ \phi_0)$$

$$= j^{\pm1} \cdot e^{j\phi}_o \cdot h(l)$$

and the zero phase $\phi_0$ of this complex carrier being an integer multiple m of $\pi/2$ ($\phi_0 = \pm m\cdot\pi/2$ where $m = 0, 1, 2, 3, ...$).

2. Method according to Claim 1, characterized in that the bandpass filter has complex coefficients $\underline{h}(k)$, in that the filter mid-frequency is exactly $f_0 = f_A/4$, and in that this filter additionally provides equalization.

3. Method according to Claim 2, characterized in that the real input signal $s(kT)$ is converted, while maintaining the sampling frequency $f_A = 1/T$ and by means of convolution with the modulated impulse response $\underline{h}(l)$, into a complex output signal

$$\underline{s}(kT) = s_1 (kT)^* \underline{h}(l)$$

$$= s_1 (k)^* h_r(l) + j s_1 (k)^* h_i(l)$$

where k is a running index.

4. Method according to Claim 1, characterized in that this filter is derived by means of frequency shifting from a filter having real coefficients $h(k)$.

5. Method according to one of the preceding claims, characterized in that the received signal is subjected to amplitude control (a.c.).

**Revendications**

1. Procédé de démodulation de signaux modulés en fréquence sous la forme $g_o(t) = a(t) \cdot \cos [\varphi(t)]$, avec la fréquence instantanée

$$\omega(t) = d \varphi(t)/dt = \omega_o [1 + \alpha \cdot v(t)],$$

le signal reçu $g_0(t)$ étant détecté à la fréquence
$f_A = 1/T$, ce qui donne

$$g_o(k) = a(k) \cdot \cos [\varphi(kT)]$$

$$= a(k) \cdot \cos [\omega_o kT + \psi(k)],$$

avec

$$\psi(k) = \Delta \Omega \cdot T \sum_{-\infty}^{k} v(k),$$

la détection du signal utile transmis v(t) prenant la forme de v(k) avec le nombre de pas k, la longueur de période de pas T, l'excursion de fréquence circulaire $\Delta\Omega = \alpha \omega_o$, la pulsation de référence $\omega_o$ et l'amplitude a(t) ou a(k), variant en fonction du temps t à cause des distorsions linéaires dans le chemin de transmission, le signal détecté $g_o(k)$ étant décalé en fréquence par multiplication complexe de la porteuse par $e^{j\omega_c kT}$, selon une nouvelle fréquence médiane $\Delta f = \Delta \omega/2\pi \approx 0$, et alors, avec un traitement complexe, par exemple par la multiplication complexe

$$\Delta g(k) = \text{Im} \{\underline{g}(k).\underline{g}^*(k(1) \text{ avec } \Delta g(k) = \text{Im} \{\underline{z}(k) \cdot \underline{z}^*(k-1)\}$$

$$\Delta g(k) = \sin [\omega(k)]$$

$$= \sin [\varphi(k-1)]$$

suivie d'une conversion Arc-Sinus, on obtient l'incrément de phase souhaité, $w(k) = \omega_o \cdot T [\Delta \omega/\omega_o + \alpha.v (k)]$. et ainsi le signal à transmettre v(k),
le signal de réception détecté $g_o(kT)$ étant soumis avant la multiplication complexe de la porteuse à un filtrage par un filtre à bande,
caractérisé en ce que
ce filtre présente des coefficients complexes $\underline{h}(k)$,
la fréquence médiane du filtre est située exactement à $f_o=f_A/4$ et,
le filtre est un filtre à demi-bande non récurant, avec des coefficients complexes pour traiter un signal d'entrée à valeur réelle s(kT), en divisant par deux la fréquence de détection fA = 1/T et en convertissant ce signal d'entrée de valeur réelle s(kT) en un signal de sortie à la valeur complexe $\underline{s}$ (2kT),
ses coefficients complexes $\underline{h}(l)$ ayant avec 1 = -(N-1)/2 jusqu'à (N-1)/2 et la longueur de filtre interne N, alternativement des valeurs réelles pures et des valeurs imaginaires pures,
la réponse impulsionnelle d'un filtre à demi-bande h(l) avec exclusivement des valeurs réelles et des propriétés :
h(1) = h(-1) pour tout
III $\leqq$ (N-1)/2 et h(1) = 0 pour 1 = ±2, ±4,...
sur la porteuse complexe reçoit en modulation une fréquence de ± 1/4 de la fréquence de détection d'entrée $f_A$ = 1/T pour donner :

$$\underline{h}(1) = h(1).e^{j(\pm 2\pi \cdot f_A/(4 f_A) + \varphi_0)}$$

$$= j^{\pm 1}.e^{j\varphi_o} \cdot h(1),$$

et la phase $\varphi_o$ de cette porteuse complexe correspond à des multiples entiers de m pour $\pi/2$ ($\varphi_o = \pm m.\pi/2$ avec m = 0,1,2,3,...).

2. Procédé selon la revendication 1,
caractérisé en ce que
le filtre à bande comporte des coefficients complexes $\underline{h}(k)$, la fréquence médiane du filtre se situe à exactement $f_o = f_A/4$ et en ce que ce filtre assure une correction supplémentaire.

**3.** Procédé selon la revendication 2,
caractérisé en ce que
le signal d'entrée réel s(kT), en conservant la fréquence de détection $f_A = 1/T$ et par convolution avec la réponse
impulsionnelle modulée $\underline{h}(1)$, est transformé en un signal de sortie complexe,

$$\underline{s}(kT) = s_1(kT)*\underline{h}(1)$$

$$= s_1(k)*h_r(1) + j\, s_1(k)*h_i(1)$$

avec k comme indice courant.

**4.** Procédé selon la revendication 1,
caractérisé en ce que
le filtre est déduit par décalage de fréquence d'un filtre à coefficients réels h(k).

**5.** Procédé selon l'une des revendications précédentes,
caractérisé en ce que
le signal d'entrée est soumis à une régulation d'amplitude (a.c.).

FIG.1

FIG.2

FIG.3

$$g(kT) = g_r(kT) + jg_i(kT)$$

FIG.4

FIG. 5

FIG. 6